# EUROPEAN PATENT APPLICATION

(11) **EP 4 657 417 A1**
(43) Date of publication of application: **03.12.2025**
(21) Application number: 24810156.0
(22) Date of filing: 26.04.2024
(51) Int. Cl.: G09G 3/20

(54) **DRIVE CIRCUIT, DRIVING METHOD, AND DISPLAY APPARATUS**

(30) Priority: 25.05.2023 CN 202310597420
(71) Applicant: Boe Technology Group Co., Ltd., Beijing 100015 (CN); Chongqing Boe Display Technology Co., Ltd., Beibei District, Chongqing 400714 (CN)
(72) Inventor: WANG, Rui, Beijing 100176 (CN); ZHANG, Runxin, Beijing 100176 (CN); HU, Ming, Beijing 100176 (CN); ZHANG, Shouqiang, Beijing 100176 (CN); QIU, Haijun, Beijing 100176 (CN); WENG, Hongtao, Beijing 100176 (CN); HUANG, Yao, Beijing 100176 (CN); TANG, Guoqiang, Beijing 100176 (CN); HUANG, Zhi, Beijing 100176 (CN); ZHAO, Yongliang, Beijing 100176 (CN); HAO, Xueguang, Beijing 100176 (CN)
(74) Representative: Isarpatent
(86) International application number: PCT/CN2024/089966
(87) International publication number: WO 2024/239909

(57) **Abstract**

The present disclosure provides a driving circuit, a driving method and a display apparatus. The driving circuit comprises a first node control circuit, a first control circuit, a second control circuit, an output node control circuit, a first energy storage circuit and an output circuit; the first control circuit controls the connection or disconnection between a second node and a first voltage line under the control of a setting control signal; the second control circuit controls the connection or disconnection between the second node and a second voltage line under the control of a first clock signal and a potential of the second node; and the output node control circuit controls the connection or disconnection between the second node and a first output node under the control of the first clock signal. The present disclosure can ensure the output stability of a driving signal on the premise of reducing the power consumption.

## Description

### CROSS REFERENCE OF RELATED APPLICATION

The present disclosure claims the priority of Chinese patent application No. 202310597420.1 filed in China on May 25, 2023, which is incorporated herein by reference in its entirety.

### TECHNICAL FIELD

The present disclosure relates to the field of display technologies, and in particular, to a driving circuit, a driving method and a display apparatus.

### BACKGROUND

The related driving circuit adopts a capacitor for controlling the potential of a second node, wherein a first end of the capacitor is electrically connected to the second node, and a second end of the capacitor is electrically connected to a clock signal line through a transistor, such that the waveform of the potential of the second node has a step caused by coupling fluctuation, the power consumption is high, and the output stability of a driving signal is low.

### SUMMARY

In a first aspect, an embodiment of the present disclosure provides a driving circuit, comprising a first node control circuit, a first control circuit, a second control circuit, an output node control circuit, a first energy storage circuit and an output circuit;
the first node control circuit is electrically connected to a first node and is configured to control a potential of the first node;
the first control circuit is electrically connected to a setting control end, a first voltage line and a second node, respectively, and is configured to control the connection or disconnection between the second node and the first voltage line under the control of a setting control signal provided by the setting control end;
the second control circuit is electrically connected to a first clock signal line, the second node and a second voltage line, respectively, and is configured to control the connection or disconnection between the second node and the second voltage line under the control of a first clock signal provided by the first clock signal line and a potential of the second node;
the output node control circuit is electrically connected to the first clock signal line, the second node and a first output node, respectively, and is configured to control the connection or disconnection between the second node and the first output node under the control of the first clock signal;
the first energy storage circuit is electrically connected to a second output node and is configured to store electric energy;
the output circuit is electrically connected to the first output node, the second output node and a driving output end, respectively, and is configured to control the driving output end to output a driving signal under the control of a potential of the first output node and a potential of the second output node.

Optionally, a first end of the first energy storage circuit is electrically connected to the second output node, and a second end of the first energy storage circuit is electrically connected to the driving output end.

Optionally, the first node and the second output node are the same node; or,
the drive circuit further comprises an on-off control circuit; the first node is electrically connected to the second output node through the on-off control circuit; a control end of the on-off control circuit is electrically connected to a third voltage line, and the on-off control circuit is configured to control the connection or disconnection between the first node and the second output node under the control of a third voltage signal provided by the third voltage line.

Optionally, the driving circuit according to at least one embodiment of the present disclosure further comprises an energy storage control circuit;
the energy storage control circuit is electrically connected to the second output node, the first clock signal line and an energy storage node, respectively, and is configured to control the connection or disconnection between the first clock signal line and the energy storage node under the control of the potential of the second output node;
a first end of the first energy storage circuit is electrically connected to the second output node, and a second end of the first energy storage circuit is electrically connected to the energy storage node.

Optionally, a first end of the first energy storage circuit is electrically connected to the second output node, and a second end of the first energy storage circuit is electrically connected to the first clock signal line.

Optionally, the driving circuit according to at least one embodiment of the present disclosure further comprises a third control circuit;
the third control circuit is electrically connected to the second output node, the first output node and a fourth voltage line, respectively, and is configured to control the connection or disconnection between the first output node and the fourth voltage line under the control of the potential of the second output node; or,
the third control circuit is electrically connected to the first node, the first output node and a fourth voltage line respectively, and is configured to control the connection or disconnection between the first output node and the fourth voltage line under the control of the potential of the first node.

Optionally, the driving circuit according to at least one embodiment of the present disclosure further comprises a fourth control circuit;
the fourth control circuit is electrically connected to the first node, a fourth voltage line and the second node, respectively, and is configured to control the connection or disconnection between the second node and the fourth voltage line under the control of the potential of the first node.

Optionally, the driving circuit according to at least one embodiment of the present disclosure further comprises a second energy storage circuit which is electrically connected to the first output node to store electric energy.

Optionally, the second control circuit comprises a first transistor and a second transistor;
a gate of the first transistor is electrically connected to the second node, a first pole of the first transistor is electrically connected to the second voltage line, and a second pole of the first transistor is electrically connected to a first pole of the second transistor;
a gate of the second transistor is electrically connected to the first clock signal line, and a second pole of the second transistor is electrically connected to the second node.

Optionally, the first control circuit comprises a third transistor; and the setting control end is an input end;
a gate of the third transistor is electrically connected to the input end, a first pole of the third transistor is electrically connected to the first voltage line, and a second pole of the third transistor is electrically connected to the second node;
the third transistor is an oxide transistor.

Optionally, the setting control end is an inverting input end; and the first control circuit comprises a third transistor;
a gate of the third transistor is electrically connected to the inverting input end, a first pole of the third transistor is electrically connected to the first voltage line, and a second pole of the third transistor is electrically connected to the second node;
the third transistor is a p-type transistor;
the inverting input end is configured to provide an inverting input signal, which is inverted from an input signal provided by the input end.

Optionally, the first output node is electrically connected to an adjacent next-stage inverting input end, and the driving output end is electrically connected to an adjacent next-stage input end.

Optionally, the first energy storage circuit comprises a first capacitor;
a first end of the first capacitor is electrically connected to the second output node, and a second end of the first capacitor is electrically connected to the driving output end.

Optionally, the first energy storage circuit comprises a first capacitor;
a first end of the first capacitor is electrically connected to the second output node, and a second end of the first capacitor is electrically connected to the first clock signal line.

Optionally, the first energy storage circuit comprises a first capacitor, and the energy storage control circuit comprises a fourth transistor;
a first end of the first capacitor is electrically connected to the second output node; and a second end of the first capacitor is electrically connected to the energy storage node;
a gate of the fourth transistor is electrically connected to the second output node, a first pole of the fourth transistor is electrically connected to the energy storage node, and a second pole of the fourth transistor is electrically connected to the first clock signal line.

Optionally, the fourth control circuit comprises a fifth transistor;
a gate of the fifth transistor is electrically connected to the first node, a first pole of the fifth transistor is electrically connected to the fourth voltage line, and a second pole of the fifth transistor is electrically connected to the second node.

Optionally, the first node control circuit is further electrically connected to an input end, a second node, a second clock signal line, a first clock signal line and a fourth voltage line, respectively, and is configured to control the connection or disconnection between the first node and the input end under the control of a second clock signal provided by the second clock signal line, and control the connection or disconnection between the first node and the fourth voltage line under the control of the first clock signal and the potential of the second node.

Optionally, the first node control circuit comprises a sixth transistor, a seventh transistor and an eighth transistor;
a gate of the sixth transistor is electrically connected to the second clock signal line, a first pole of the sixth transistor is electrically connected to the input end, and a second pole of the sixth transistor is electrically connected to the first node;
a gate of the seventh transistor is electrically connected to the first clock signal line, a first pole of the seventh transistor is electrically connected to the fourth voltage line, and a second pole of the seventh transistor is electrically connected to a first pole of the eighth transistor;
a gate of the eighth transistor is electrically connected to the second node, and a second pole of the eighth transistor is electrically connected to the first node.

Optionally, the third control circuit comprises a ninth transistor;
a gate of the ninth transistor is electrically connected to the second output node, a first pole of the ninth transistor is electrically connected to the fourth voltage line, and a second pole of the ninth transistor is electrically connected to the first output node.

Optionally, the output node control circuit comprises a tenth transistor;
a gate of the tenth transistor is electrically connected to the first clock signal line, a first pole of the tenth transistor is electrically connected to the second node, and a second pole of the tenth transistor is electrically connected to the first output node.

Optionally, the driving circuit further comprises an on-off control circuit;
the on-off control circuit comprises an eleventh transistor;
a gate of the eleventh transistor is electrically connected to the third voltage line, a first pole of the eleventh transistor is electrically connected to the first node, and a second pole of the eleventh transistor is electrically connected to the second output node.

Optionally, the output circuit comprises a twelfth transistor and a thirteenth transistor;
a gate of the twelfth transistor is electrically connected to the first output node, a first pole of the twelfth transistor is electrically connected to a fifth voltage line, and a second pole of the twelfth transistor is electrically connected to the driving output end;
a gate of the thirteenth transistor is electrically connected to the second output node, a first pole of the thirteenth transistor is electrically connected to the driving output end, and a second pole of the thirteenth transistor is electrically connected to a sixth voltage line.

In a second aspect, an embodiment of the present disclosure provides a driving method applied to the aforementioned driving circuit, the driving method comprising:
controlling, by a first node control circuit, a potential of a first node;
controlling, by a first control circuit, the connection or disconnection between a second node and a first voltage line under the control of a setting control signal;
controlling, by a second control circuit, the connection or disconnection between the second node and a second voltage line under the control of a first clock signal and a potential of the second node;
controlling, by an output node control circuit, the connection or disconnection between the second node and a first output node under the control of the first clock signal; and
controlling, by an output circuit, a driving output end to output a driving signal under the control of a potential of the first output node and a potential of a second output node.

In a third aspect, an embodiment of the present disclosure provides a display apparatus, comprising the aforementioned driving circuit.

### BRIEF DESCRIPTION OF THE DRAWINGS

FIG. 1 illustrates a structural diagram of a driving circuit according to at least one embodiment of the present disclosure;
FIG. 2 illustrates a structural diagram of a driving circuit according to at least one embodiment of the present disclosure;
FIG. 3 illustrates a structural diagram of a driving circuit according to at least one embodiment of the present disclosure;
FIG. 4 illustrates a structural diagram of a driving circuit according to at least one embodiment of the present disclosure;
FIG. 5 illustrates a structural diagram of a driving circuit according to at least one embodiment of the present disclosure;
FIG. 6 illustrates a structural diagram of a driving circuit according to at least one embodiment of the present disclosure;
FIG. 7 illustrates a structural diagram of a driving circuit according to at least one embodiment of the present disclosure;
FIG. 8 illustrates a structural diagram of a driving circuit according to at least one embodiment of the present disclosure;
FIG. 9 illustrates a structural diagram of a driving circuit according to at least one embodiment of the present disclosure;
FIG. 10 illustrates a circuit diagram of a driving circuit according to at least one embodiment of the present disclosure;
FIG. 11 illustrates an operation timing diagram of at least one implementation of the driving circuit shown in FIG. 10;
FIG. 12 illustrates a simulation operation timing diagram of at least one implementation of the driving circuit shown in FIG. 10;
FIG. 13 illustrates a circuit diagram of a driving circuit according to at least one embodiment of the present disclosure;
FIG. 14 illustrates a simulation operation timing diagram of at least one implementation of the driving circuit shown in FIG. 13;
FIG. 15A illustrates a waveform diagram of a potential of a first node N1 and a driving signal in at least one implementation of the driving circuit shown in FIG. 10;
FIG. 15B illustrates a waveform diagram of a potential of a first node N1, a potential of a second output node NO2 and a driving signal in at least one implementation of the driving circuit shown in FIG. 13;
FIG. 16 illustrates a circuit diagram of a driving circuit according to at least one embodiment of the present disclosure;
FIG. 17 illustrates an operation timing diagram of at least one implementation of the driving circuit shown in FIG. 16;
FIG. 18 illustrates a circuit diagram of a driving circuit according to at least one embodiment of the present disclosure;
FIG. 19 illustrates an operation timing diagram of at least one implementation of the driving circuit shown in FIG. 18;
FIG. 20 illustrates a circuit diagram of a driving circuit according to at least one embodiment of the present disclosure;
FIG. 21 illustrates a layout diagram of at least one implementation of the driving circuit shown in FIG. 10;
FIG. 22 illustrates a layout diagram of a first semiconductor layer in FIG. 21;
FIG. 23 illustrates a layout diagram of a first gate metal layer in FIG. 21;
FIG. 24 illustrates a layout diagram of a second gate metal layer in FIG. 21;
FIG. 25 illustrates a layout diagram of a third gate metal layer in FIG. 21;
FIG. 26 illustrates a layout diagram of a second semiconductor layer in FIG. 21; and
FIG. 27 illustrates a layout diagram of a source-drain metal layer in FIG. 21.

### DETAILED DESCRIPTION

The technical solutions in the embodiments of the present disclosure will be clearly and completely described below with reference to the drawings for the embodiments of the present disclosure. Obviously, those described are only a part, rather than all, of the embodiments of the present disclosure. Based on the embodiments of the present disclosure, any other embodiment obtained by persons of ordinary skill in the art without paying any creative effort should fall within the protection scope of the present disclosure.

The transistor in any embodiment of the present disclosure may be a thin film transistor or a field effect transistor or any other device with the same characteristics. In the embodiments of the present disclosure, in order to distinguish the two poles of the transistor except a gate, one of the poles is called as a first pole and the other thereof is called as a second pole.

In actual operations, when the transistor is a thin film transistor or a field effect transistor, the first pole may be a drain and the second pole may be a source; or the first pole may be a source and the second pole may be a drain.

A driving circuit according to an embodiment of the present disclosure includes a first node control circuit, a first control circuit, a second control circuit, an output node control circuit, a first energy storage circuit and an output circuit;
the first node control circuit is electrically connected to the first node and is configured to control a potential of the first node;
the first control circuit is electrically connected to a setting control end, a first voltage line and a second node, respectively, and is configured to control the connection or disconnection between the second node and the first voltage line under the control of a setting control signal provided by the setting control end;
the second control circuit is electrically connected to a first clock signal line, the second node and a second voltage line, respectively, and is configured to control the connection or disconnection between the second node and the second voltage line under the control of a first clock signal provided by the first clock signal line and a potential of the second node;
the output node control circuit is electrically connected to the first clock signal line, the second node and a first output node, respectively, and is configured to control the connection or disconnection between the second node and the first output node under the control of the first clock signal;
the first energy storage circuit is electrically connected to a second output node and is configured to store electric energy;
the output circuit is electrically connected to the first output node, the second output node and a driving output end, respectively, and is configured to control the driving output end to output a driving signal under the control of a potential of the first output node and a potential of the second output node.

The driving circuit according to the embodiment of the present disclosure controls the potential of the second node by adopting the first control circuit and the second control circuit, and compared with the related driving circuit, the capacitor for controlling the potential of the second node is omitted, which is beneficial to realizing a narrow frame. Moreover, in the embodiment of the present disclosure, the second control circuit can control the stability of the potential of the second node, and a capacitor electrically connected to the second node (a first end of the capacitor is electrically connected to the second node, and a second end of the capacitor is electrically connected to a clock signal line through a transistor) is not adopted, so that a waveform of the potential of the second node can be free from a step caused by coupling fluctuation, and the embodiment of the present disclosure can ensure the output stability of the driving signal on the premise of reducing the power consumption.

In at least one embodiment of the present disclosure, the first node and the second output node are the same node; or,
the drive circuit further includes an on-off control circuit; the first node is electrically connected to the second output node through the on-off control circuit; a control end of the on-off control circuit is electrically connected to a third voltage line, and the on-off control circuit is configured to control the connection or disconnection between the first node and the second output node under the control of a third voltage signal provided by the third voltage line.

During implementation, the first node and the second output node may be the same node, or may be electrically connected through the on-off control circuit.

Optionally, the first voltage line may be a first low voltage line and the second voltage line may be a second low voltage line.

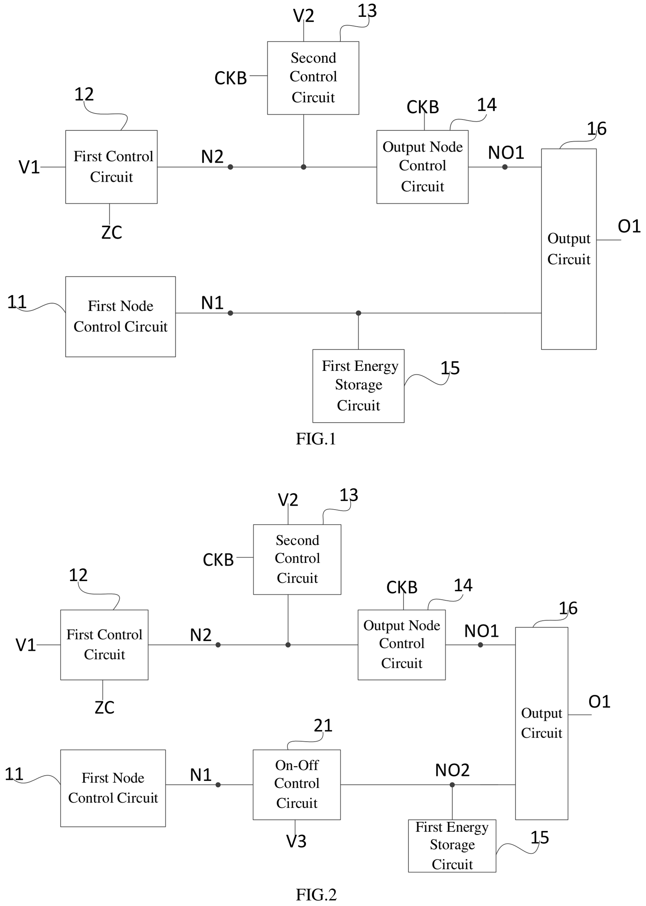

As shown in FIG. 1, the driving circuit according to the embodiment of the present disclosure includes a first node control circuit 11, a first control circuit 12, a second control circuit 13, an output node control circuit 14, a first energy storage circuit 15 and an output circuit 16;
the first node control circuit 11 is electrically connected to the first node N1 to control a potential of the first node N1.
the first control circuit 12 is electrically connected to a setting control end ZC, a first voltage line V1 and a second node N2, respectively, and is configured to control the connection or disconnection between the second node N2 and the first voltage line V1 under the control of a setting control signal provided by the setting control end ZC;
the second control circuit 13 is electrically connected to a first clock signal line CKB, the second node N2 and a second voltage line V2, respectively, and is configured to control the connection or disconnection between the second node N2 and the second voltage line V2 under the control of a first clock signal provided by the first clock signal line CKB and a potential of the second node N2;
the output node control circuit 14 is electrically connected to the first clock signal line CKB, the second node N2 and a first output node NO1, respectively, and is configured to control the connection or disconnection between the second node N2 and the first output node NO1 under the control of the first clock signal;
the first energy storage circuit 15 is electrically connected to the first node N1 to store electric energy;
the output circuit 16 is electrically connected to the first output node NO1, the first node N1 and a driving output end O1, respectively, and is configured to control the driving output end O1 to output a driving signal under the control of a potential of the first output node NO1 and the potential of the first node N1.

In at least one embodiment shown in FIG. 1, the second output node and the first node N1 are the same node.

As shown in FIG. 2, the driving circuit according to the embodiment of the present disclosure includes a first node control circuit 11, a first control circuit 12, a second control circuit 13, an output node control circuit 14, a first energy storage circuit 15, an output circuit 16 and an on-off control circuit 21;
the first node N1 is electrically connected to a second output node NO2 through the on-off control circuit 21; a control end of the on-off control circuit 21 is electrically connected to a third voltage line V3, and the on-off control circuit 21 is configured to control the connection or disconnection between the first node N1 and the second output node NO2 under the control of a third voltage signal provided by the third voltage line V3;
the first node control circuit 11 is electrically connected to the first node N1 to control a potential of the first node N1;
the first control circuit 12 is electrically connected to a setting control end ZC, a first voltage line V1 and a second node N2, respectively, and is configured to control the connection or disconnection between the second node N2 and the first voltage line V1 under the control of a setting control signal provided by the setting control end ZC;
the second control circuit 13 is electrically connected to a first clock signal line CKB, the second node N2 and a second voltage line V2, respectively, and is configured to control the connection or disconnection between the second node N2 and the second voltage line V2 under the control of a first clock signal provided by the first clock signal line CKB and a potential of the second node N2;
the output node control circuit 14 is electrically connected to the first clock signal line CKB, the second node N2 and a first output node NO1, respectively, and is configured to control the connection or disconnection between the second node N2 and the first output node NO1 under the control of the first clock signal;
the first energy storage circuit 15 is electrically connected to the second output node NO2 to store electric energy;
the output circuit 15 is electrically connected to the first output node NO1, the second output node NO2 and a driving output end O1, respectively, and is configured to control the driving output end O1 to output a driving signal under the control of a potential of the first output node NO1 and a potential of the second output node NO2.

In at least one embodiment shown in FIG. 2, an on-off control circuit 21 controlled by a third voltage line V3 is provided between the first node N1 and the second output node NO2.

Optionally, the third voltage line V3 may be a first low voltage line, which is not limited herein.

In at least one embodiment of the present disclosure, a first end of the first energy storage circuit is electrically connected to the second output node, and a second end of the first energy storage circuit is electrically connected to the driving output end.

During implementation, the second end of the first energy storage circuit may be electrically connected to the driving output end instead of the clock signal line, so that the potential of the second output node does not have a step caused by the coupling effect of the first energy storage circuit, and the potential of the second output node can be stabilized, thereby improving the stability of the driving signal output by the driving circuit.

The driving circuit according to at least one embodiment of the present disclosure may further include an energy storage control circuit;
the energy storage control circuit is electrically connected to the second output node, the first clock signal line and an energy storage node, respectively, and is configured to control the connection or disconnection between the first clock signal line and the energy storage node under the control of the potential of the second output node;
a first end of the first energy storage circuit is electrically connected to the second output node, and a second end of the first energy storage circuit is electrically connected to the energy storage node.

In at least one embodiment of the present disclosure, the driving circuit may further include an energy storage control circuit configured to control the connection or disconnection between the first clock signal line and the energy storage node under the control of the potential of the second output node.

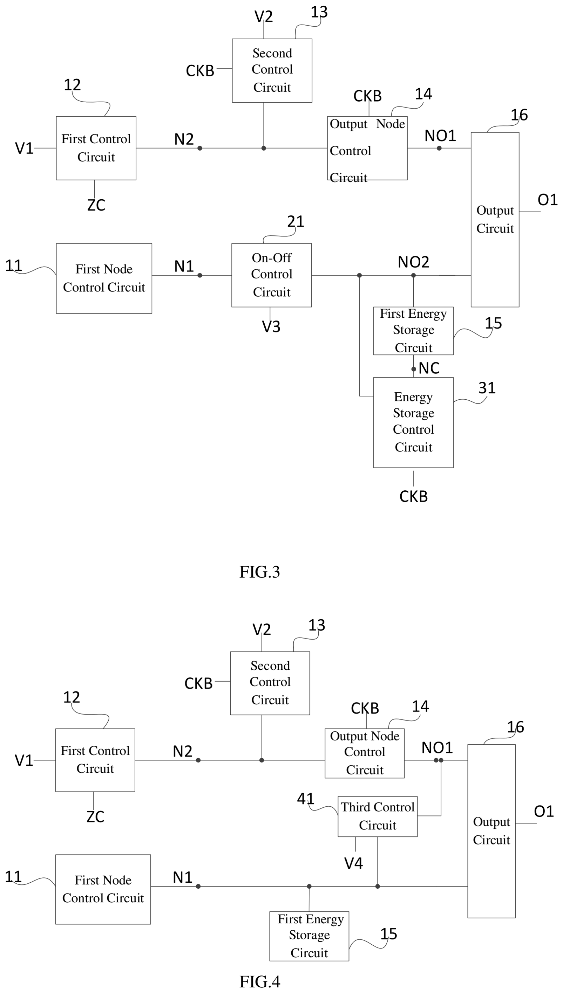

As shown in FIG. 3, based on at least one implementation of the driving circuit shown in FIG. 2, the driving circuit according to at least one embodiment of the present disclosure further includes an energy storage control circuit 31;
the energy storage control circuit 31 is electrically connected to the second output node NO2, the first clock signal line CKB and an energy storage node NC, respectively, and is configured to control the connection or disconnection between the first clock signal line CKB and the energy storage node NC under the control of a potential of the second output node NO2;
a first end of the first energy storage circuit 15 is electrically connected to the second output node NO2, and a second end of the first energy storage circuit 15 is electrically connected to the energy storage node NC.

During the operation of at least one implementation of the driving circuit shown in FIG. 3 of the present disclosure, when the potential of NO1 is a low volage, and the potential of NO1 will be pulled down every time the potential of the first clock signal provided by CKB is set as a low voltage, so that a reset transistor included in the output circuit is completely turned on, and the driving signal output by the driving circuit is more stable.

Optionally, a first end of the first energy storage circuit is electrically connected to the second output node, and a second end of the first energy storage circuit is electrically connected to the first clock signal line.

During implementation, the first energy storage circuit may be electrically connected to the second output node and the first clock signal line, respectively.

The driving circuit according to at least one embodiment of the present disclosure further includes a third control circuit;
the third control circuit is electrically connected to the second output node, the first output node and a fourth voltage line, respectively, and is configured to control the connection or disconnection between the first output node and the fourth voltage line under the control of the potential of the second output node; or,
the third control circuit is electrically connected to the first node, the first output node and a fourth voltage line respectively, and is configured to control the connection or disconnection between the first output node and the fourth voltage line under the control of the potential of the first node.

During implementation, the pixel circuit may further include a third control circuit, which can control the connection or disconnection between the first output node and the fourth voltage line under the control of the potential of the second output node or the potential of the first node, so as to control the potential of the first output node to be a high volage when the potential of the second output node and/or the potential of the first node is a low-voltage signal.

Optionally, the fourth voltage line may be a high voltage line.

As shown in FIG. 4, based on at least one implementation of the driving circuit shown in FIG. 1, the driving circuit according to at least one embodiment of the present disclosure may further include a third control circuit 41;
the third control circuit 41 is electrically connected to a first node N1, a first output node NO1 and a fourth voltage line V4, respectively, and is configured to control the connection or disconnection between the first output node NO1 and the fourth voltage line V4 under the control of a potential of the first node N1.

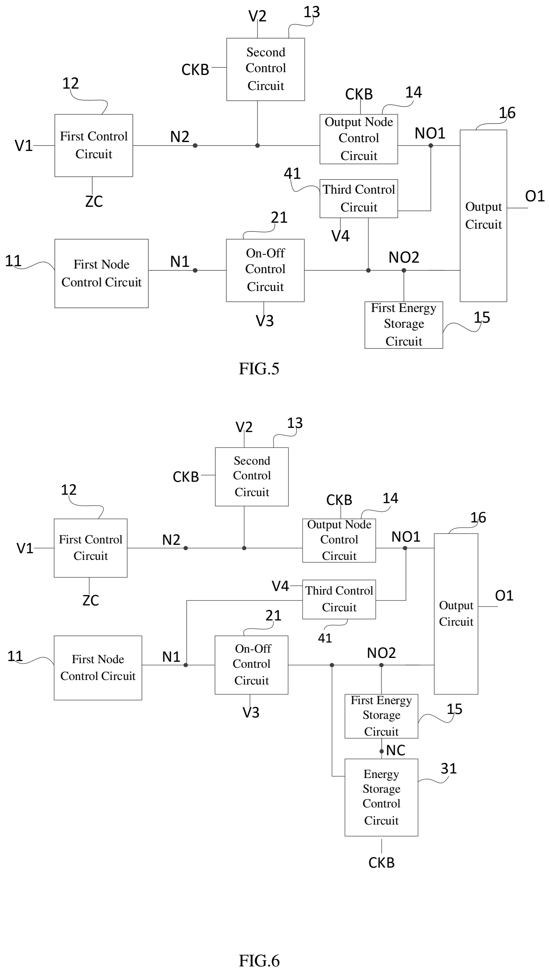

As shown in FIG. 5, based on at least one implementation of the driving circuit shown in FIG. 2, the driving circuit according to at least one embodiment of the present disclosure may further include a third control circuit 41;
the third control circuit 41 is electrically connected to a second output node NO2, a first output node NO1 and a fourth voltage line V4, respectively, and is configured to control the connection or disconnection between the first output node NO1 and the fourth voltage line V4 under the control of a potential of the second output node NO2.

As shown in FIG. 6, based on at least one implementation of the driving circuit shown in FIG. 3, the driving circuit according to at least one embodiment of the present disclosure may further include a third control circuit 41;
the third control circuit 41 is electrically connected to a first node N1, a first output node NO1 and a fourth voltage line V4, respectively, and is configured to control the connection or disconnection between the first output node NO1 and the fourth voltage line V4 under the control of a potential of the first node N1.

In at least one embodiment of the present disclosure, the driving circuit may further include a fourth control circuit;
the fourth control circuit is electrically connected to the first node, a fourth voltage line and the second node, respectively, and is configured to control the connection or disconnection between the second node and the fourth voltage line under the control of the potential of the first node.

During implementation, the driving circuit may further include a fourth control circuit, which controls the connection or disconnection between the second node and the fourth voltage line under the control of the potential of the first node, so as to control the potential of the second node to be a high voltage when the potential of the first node is at a low voltage.

The driving circuit according to at least one embodiment of the present disclosure further includes a second energy storage circuit which is electrically connected to the first output node to store electric energy.

Optionally, the second control circuit includes a first transistor and a second transistor;
a gate of the first transistor is electrically connected to the second node, a first pole of the first transistor is electrically connected to the second voltage line, and a second pole of the first transistor is electrically connected to a first pole of the second transistor;
a gate of the second transistor is electrically connected to the first clock signal line, and a second pole of the second transistor is electrically connected to the second node.

In at least one embodiment of the present disclosure, the first control circuit may include a third transistor; and the setting control end is an input end;
a gate of the third transistor is electrically connected to the input end, a first pole of the third transistor is electrically connected to the first voltage line, and a second pole of the third transistor is electrically connected to the second node;
the third transistor is an oxide transistor.

In at least one embodiment of the present disclosure, the setting control end may be an inverting input end; and the first control circuit includes a third transistor;
a gate of the third transistor is electrically connected to the inverting input end, a first pole of the third transistor is electrically connected to the first voltage line, and a second pole of the third transistor is electrically connected to the second node;
the third transistor is a p-type transistor;
the inverting input end is configured to provide an inverting input signal, which is inverted from an input signal provided by the input end.

In at least one embodiment of the present disclosure, the first output node is electrically connected to an adjacent next-stage inverting input end, and the driving output end is electrically connected to an adjacent next-stage input end.

Optionally, the first energy storage circuit includes a first capacitor;
a first end of the first capacitor is electrically connected to the second output node, and a second end of the first capacitor is electrically connected to the driving output end.

Optionally, the first energy storage circuit includes a first capacitor;
a first end of the first capacitor is electrically connected to the second output node, and a second end of the first capacitor is electrically connected to the first clock signal line.

In at least one embodiment of the present disclosure, the first energy storage circuit includes a first capacitor, and the energy storage control circuit includes a fourth transistor;
a first end of the first capacitor is electrically connected to the second output node; and a second end of the first capacitor is electrically connected to the energy storage node;
a gate of the fourth transistor is electrically connected to the second output node, a first pole of the fourth transistor is electrically connected to the energy storage node, and a second pole of the fourth transistor is electrically connected to the first clock signal line.

Optionally, the fourth control circuit includes a fifth transistor;
a gate of the fifth transistor is electrically connected to the first node, a first pole of the fifth transistor is electrically connected to the fourth voltage line, and a second pole of the fifth transistor is electrically connected to the second node.

In at least one embodiment of the present disclosure, the first node control circuit is further electrically connected to an input end, a second node, a second clock signal line, a first clock signal line and a fourth voltage line, respectively, and is configured to control the connection or disconnection between the first node and the input end under the control of a second clock signal provided by the second clock signal line, and control the connection or disconnection between the first node and the fourth voltage line under the control of the first clock signal and the potential of the second node.

During implementation, the first node control circuit may control the connection or disconnection between the first node and the input end under the control of a second clock signal, and control the connection or disconnection between the first node and the fourth voltage line under the control of the first clock signal and the potential of the second node to control the potential of the first node.

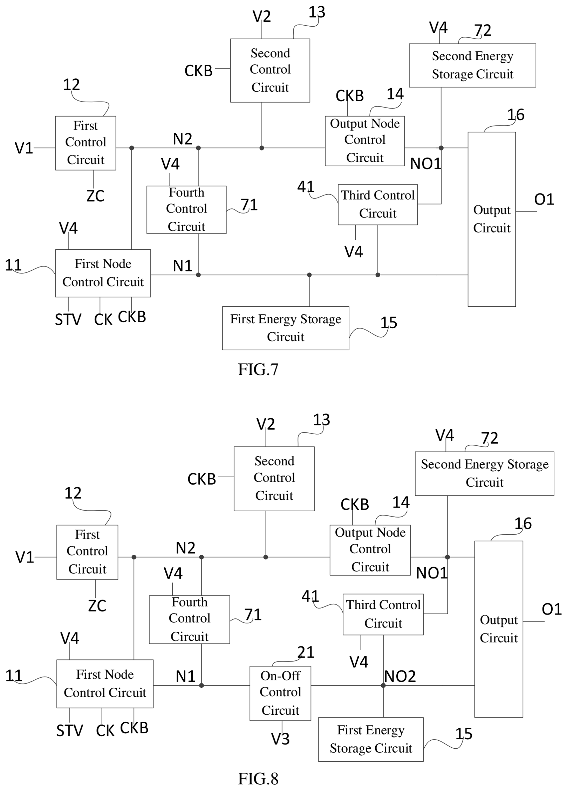

As shown in FIG. 7, based on at least one implementation of the driving circuit shown in FIG. 4, the driving circuit according to at least one embodiment of the present disclosure may further include a fourth control circuit 71 and a second energy storage circuit 72;
the fourth control circuit 71 is electrically connected to the first node N1, a fourth voltage line V4 and the second node N2, respectively, and is configured to control the connection or disconnection between the second node N2 and the fourth voltage line V4 under the control of the potential of the first node N1;
the second energy storage circuit 72 is electrically connected to the first output node NO1 and the fourth voltage line V4, respectively, to store electric energy;
the first node control circuit 11 is further electrically connected to an input end STV, a second node N2, a second clock signal line CK, a first clock signal line CKB and a fourth voltage line V4, respectively, and is configured to control the connection or disconnection between the first node N1 and the input end STV under the control of a second clock signal provided by the second clock signal line CK, and control the connection or disconnection between the first node N1 and the fourth voltage line V4 under the control of a first clock signal and a potential of the second node N2.

During the operation of at least one implementation of the driving circuit shown in FIG. 7 of the present disclosure, the fourth control circuit 70 may control the potential of N2 to be a high voltage when the potential of the first node N1 is at a low voltage, and the second energy storage circuit 72 can maintain the potential of the first output node NO1. The first node control circuit 11 controls the potential of the first node N1 under the control of the second clock signal, the first clock signal and the potential of the second node N2.

As shown in FIG. 8, based on at least one implementation of the driving circuit shown in FIG. 5, the driving circuit according to at least one embodiment of the present disclosure may further include a fourth control circuit 71 and a second energy storage circuit 72;
the fourth control circuit 71 is electrically connected to the first node N1, a fourth voltage line V4 and the second node N2, respectively, and is configured to control the connection or disconnection between the second node N2 and the fourth voltage line V4 under the control of a potential of the first node N1;
the second energy storage circuit 72 is electrically connected to the first output node NO1 and the fourth voltage line V4, respectively, to store electric energy;
the first node control circuit 11 is further electrically connected to an input end STV, a second node N2, a second clock signal line CK, a first clock signal line CKB and a fourth voltage line V4, respectively, and is configured to control the connection or disconnection between the first node N1 and the input end STV under the control of a second clock signal provided by the second clock signal line CK, and control the connection or disconnection between first node N1 and the fourth voltage line V4 under the control of the first clock signal and a potential of the second node N2.

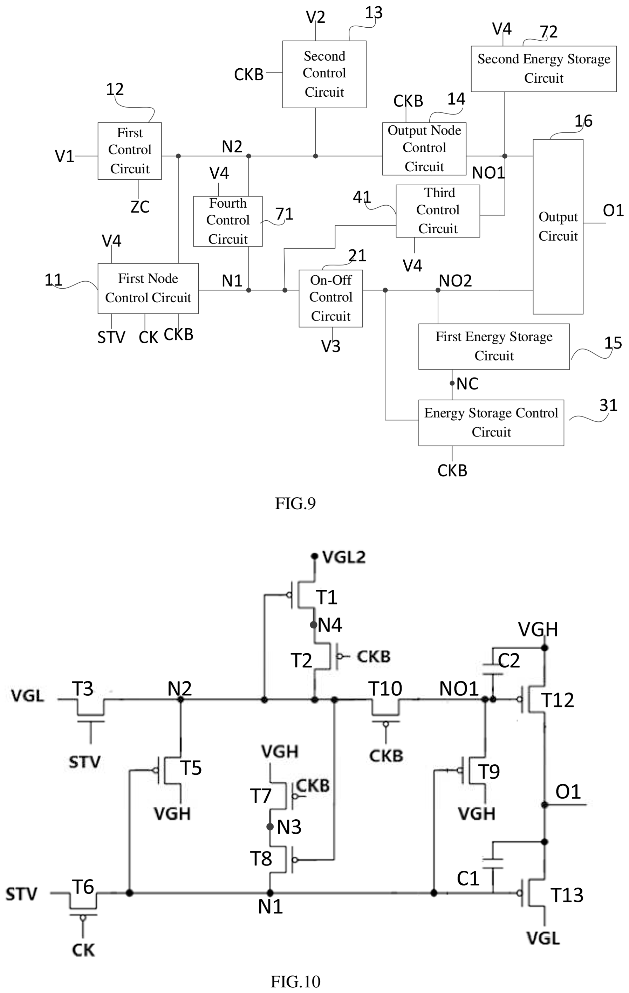

As shown in FIG. 9, based on at least one implementation of the driving circuit shown in FIG. 6, the driving circuit according to at least one embodiment of the present disclosure may further include a fourth control circuit 71 and a second energy storage circuit 72;
the fourth control circuit 71 is electrically connected to the first node N1, a fourth voltage line V4 and the second node N2, respectively, and is configured to control the connection or disconnection between the second node N2 and the fourth voltage line V4 under the control of a potential of the first node N1;
the second energy storage circuit 72 is electrically connected to the first output node NO1 and the fourth voltage line V4, respectively, to store electric energy;
the first node control circuit 11 is further electrically connected to an input end STV, a second node N2, a second clock signal line CK, a first clock signal line CKB and a fourth voltage line V4, respectively, and is configured to control the connection or disconnection between the first node N1 and the input end STV under the control of a second clock signal provided by the second clock signal line CK, and control the connection or disconnection between the first node N1 and the fourth voltage line V4 under the control of the first clock signal and a potential of the second node N2.

Optionally, the first node control circuit includes a sixth transistor, a seventh transistor and an eighth transistor;
a gate of the sixth transistor is electrically connected to the second clock signal line, a first pole of the sixth transistor is electrically connected to the input end, and a second pole of the sixth transistor is electrically connected to the first node;
a gate of the seventh transistor is electrically connected to the first clock signal line, a first pole of the seventh transistor is electrically connected to the fourth voltage line, and a second pole of the seventh transistor is electrically connected to a first pole of the eighth transistor;
a gate of the eighth transistor is electrically connected to the second node, and a second pole of the eighth transistor is electrically connected to the first node.

Optionally, the third control circuit includes a ninth transistor;
a gate of the ninth transistor is electrically connected to the second output node, a first pole of the ninth transistor is electrically connected to the fourth voltage line, and a second pole of the ninth transistor is electrically connected to the first output node.

Optionally, the output node control circuit includes a tenth transistor;
a gate of the tenth transistor is electrically connected to the first clock signal line, a first pole of the tenth transistor is electrically connected to the second node, and a second pole of the tenth transistor is electrically connected to the first output node.

In at least one embodiment of the present disclosure, the driving circuit may further include an on-off control circuit;
the on-off control circuit includes an eleventh transistor;
a gate of the eleventh transistor is electrically connected to the third voltage line, a first pole of the eleventh transistor is electrically connected to the first node, and a second pole of the eleventh transistor is electrically connected to the second output node.

Optionally, the output circuit includes a twelfth transistor and a thirteenth transistor;
a gate of the twelfth transistor is electrically connected to the first output node, a first pole of the twelfth transistor is electrically connected to a fifth voltage line, and a second pole of the twelfth transistor is electrically connected to the driving output end;
a gate of the thirteenth transistor is electrically connected to the second output node, a first pole of the thirteenth transistor is electrically connected to the driving output end, and a second pole of the thirteenth transistor is electrically connected to a sixth voltage line.

In at least one embodiment of the present disclosure, the fifth voltage line may be a high voltage line and the sixth voltage line may be a first low voltage line, which are not limited herein.

As shown in FIG. 10, based on at least one implementation of the driving circuit shown in FIG. 7,
the first node control circuit includes a sixth transistor T6, a seventh transistor T7 and an eighth transistor T8;
a gate of the sixth transistor T6 is electrically connected to the second clock signal line CK, a source of the sixth transistor T6 is electrically connected to the input end STV, and a drain of the sixth transistor T6 is electrically connected to the first node N1;
a gate of the seventh transistor T7 is electrically connected to the first clock signal line CKB, a source of the seventh transistor T7 is electrically connected to a high voltage line VGH, and a drain of the seventh transistor T7 is electrically connected to a source of the eighth transistor T8;
a gate of the eighth transistor T8 is electrically connected to the second node N2, and a drain of the eighth transistor T8 is electrically connected to the first node N1;
the third control circuit includes a ninth transistor T9;
a gate of the ninth transistor T9 is electrically connected to the first node N1, a source of the ninth transistor T9 is electrically connected to a high voltage line VGH, and a drain of the ninth transistor T9 is electrically connected to the first output node NO1;
the output node control circuit includes a tenth transistor T10;
a gate of the tenth transistor T10 is electrically connected to the first clock signal line CKB, a source of the tenth transistor T10 is electrically connected to the second node N2, and a drain of the tenth transistor T10 is electrically connected to the first output node NO1;
the second control circuit includes a first transistor T1 and a second transistor T2;
a gate of the first transistor T1 is electrically connected to the second node N2, a source of the first transistor T1 is electrically connected to a second low voltage line VGL2, and a drain of the first transistor T1 is electrically connected to a source of the second transistor T2;
a gate of the second transistor T2 is electrically connected to the first clock signal line CKB, and a drain of the second transistor T2 is electrically connected to the second node N2;
the first control circuit includes a third transistor T3; and the setting control end is an input end STV;
a gate of the third transistor T3 is electrically connected to the input end STV, a source of the third transistor T3 is electrically connected to a low voltage line VGL, and a drain of the third transistor T3 is electrically connected to the second node N2;
the third transistor T3 is an oxide transistor;
the first energy storage circuit includes a first capacitor C1;
a first end of C1 is electrically connected to the first node N1, and a second end of C1 is electrically connected to the driving output end O1;
the fourth control circuit includes a fifth transistor T5;
a gate of the fifth transistor T5 is electrically connected to the first node N1, a source of the fifth transistor T5 is electrically connected to a high voltage line VGH, and a drain of the fifth transistor T5 is electrically connected to the second node N2;
the second energy storage circuit includes a second capacitor C2;
a first end of the second capacitor C2 is electrically connected to the first output node NO1, and a second end of the second capacitor C2 is electrically connected to a high voltage line VGH;
the output circuit includes a twelfth transistor T12 and a thirteenth transistor T13;
a gate of the twelfth transistor T12 is electrically connected to the first output node NO1, a source of the twelfth transistor T12 is electrically connected to a high voltage line VGH, and a drain of the twelfth transistor T12 is electrically connected to the driving output end O1;
a gate of the thirteenth transistor T13 is electrically connected to the first node N1, a source of the thirteenth transistor T13 is electrically connected to the driving output end O1, and a drain of the thirteenth transistor T13 is electrically connected to the first low voltage line VGL.

In at least one implementation of the driving circuit shown in FIG. 10, T3 is an N-type transistor and T6 may be a double-gate transistor to prevent a leakage;
the transistors except T3 in FIG. 10 may all be p-type transistors.

In at least one implementation of the driving circuit shown in FIG. 10, N3 is a third node and N4 is a fourth node; the third node N3 is a connection node between T7 and T8, and a fourth node N4 is a connection node between T1 and T2.

In at least one embodiment of the present disclosure, a voltage value of a first low-voltage signal provided by VGL may be greater than or equal to -10V and less than or equal to -7V, a voltage value of a second low-voltage signal provided by VGL2 may be greater than or equal to -10V and less than or equal to -7V, and the voltage value of the first low-voltage signal may be or may not be equal to that of the second low-voltage signal.

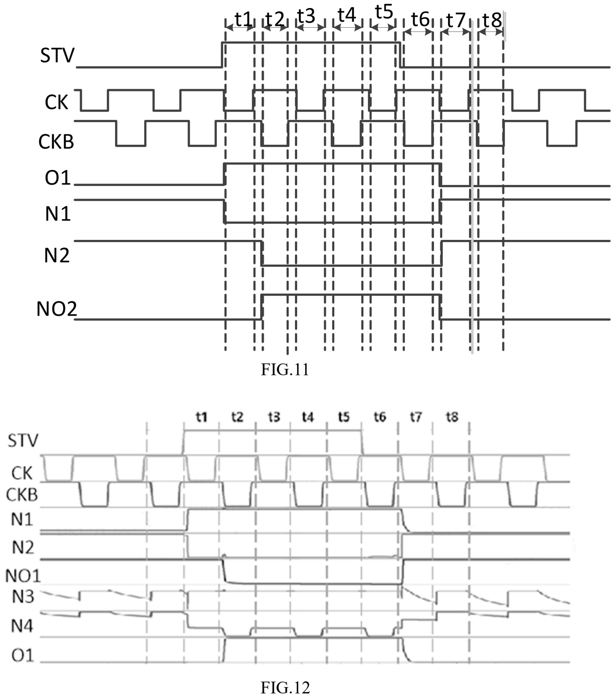

As shown in FIG. 11, during the operation of at least one implementation of the driving circuit shown in FIG. 10 of the present disclosure, a display cycle may include a first stage t1, a second stage t2, a third stage t3, a fourth stage t4, a fifth stage t5, a sixth stage t6, a seventh stage t7 and an eighth stage t8 which are set in sequence;
in the first stage t1, STV provides a high-voltage signal, CKB provides a high-voltage signal, CK provides a low-voltage signal, T6 and T3 are turned on, the potential of N2 is at a low voltage, T8 is turned on, T1 is turned on, the potential of N1 is at a high voltage, the potential of NO1 is at a high voltage, and the potential of the driving signal output by O1 remains at a low voltage;

In the second stage t2, STV provides a high-voltage signal, CK provides a high-voltage signal, CKB provides a low-voltage signal, T3 is turned on, the potential of N2 is at a low voltage, T2 is turned on, T10 is turned on, the potential of NO1 is at a low voltage, T12 is turned on, and O1 outputs a high-voltage signal; T7 and T8 are turned on, the potential of N1 is at a high voltage, and T13 is turned off;
in the third stage t3, STV provides a high-voltage signal, CK provides a low-voltage signal, CKB provides a high-voltage signal, T6 and T3 are turned on, the potential of N2 is at a low voltage, the potential of N1 is at a high voltage, T1 is turned on, T2 is turned off, T8 is turned on, T7 is turned off, T10 is turned off, the potential of NO1 is maintained at a low voltage, T12 is turned on, T13 is turned off, and O1 outputs a high-voltage signal;
in the fourth stage t4, STV provides a high-voltage signal, CK provides a high-voltage signal, CKB provides a low-voltage signal, T3 is turned on, the potential of N2 is at a low voltage, T2 is turned on, T10 is turned on, the potential of NO1 is at a low voltage, T12 is turned on, and O1 outputs a high-voltage signal; T7 and T8 are turned on, the potential of N1 is at a high voltage, and T13 is turned off;
in the fifth stage t5, STV provides a high-voltage signal, CK provides a low-voltage signal, CKB provides a high-voltage signal, T6 and T3 are turned on, the potential of N2 is at a low voltage, the potential of N1 is at a high voltage, T1 is turned on, T2 is turned off, T8 is turned on, T7 is turned off, T10 is turned off, the potential of NO1 is maintained at a low voltage, T12 is turned on, T13 is turned off, and O1 outputs a high-voltage signal;
in the sixth stage t6, STV provides a low-voltage signal, CK provides a high-voltage signal, CKB provides a low-voltage signal, T7 is turned on, the potential of N2 is maintained at a low voltage, T8 is turned on, the potential of N1 is at a high voltage, T13 is turned off, T10 is turned on, the potential of NO1 is at a low voltage, T12 is turned on, and O1 outputs a high-voltage signal;
in the seventh stage t7, STV provides a low-voltage signal, CK provides a low-voltage signal, CKB provides a high-voltage signal, T6 is turned on, the potential of N1 is at a low voltage, T13 is turned on, O1 outputs a low-voltage signal, T9 is turned on, the potential of NO1 is at a high voltage, T5 is turned on, and the potential of N2 is at a high voltage;
in the eighth stage t8, STV provides a low-voltage signal, CK provides a high-voltage signal, CKB provides a low-voltage signal, both T6 and T3 are turned off, the potential of N2 is maintained at a high voltage, the potential of N1 is maintained at a low voltage, T9 is turned on, the potential of NO1 is at a high voltage, T12 is turned off, T13 is turned on, and O1 outputs a low-voltage signal.

During the operation of at least one implementation of the driving circuit shown in FIG. 10,
when O1 outputs a low-voltage signal, the potential of N1 maintained by C1 will leak through T6, and T6 may be designed as a double-gate transistor to prevent a leakage;
T1 and T2 may stabilize the voltage of N2. From the first stage t1 to the fifth stage t5, N2 is always written with a low-voltage signal by T3, and the potential of N2 is maintained at a low voltage. In the sixth stage t6, the potential of the input signal provided by STV is set low, and T3 is turned off, but T12 needs to be turned on so that O1 can continuously output a high-voltage signal. At this time, N2 is written with low-voltage signals by T1 and T2, and T10 is turned on. At this time, the potential of NO1 is at a low voltage, T12 is turned on, and O1 outputs a high-voltage signal.

In at least one implementation of the driving circuit shown in FIG. 10, the second end of C1 is electrically connected to the driving output end O1, and the second end of C1 is not electrically connected to the clock signal line, so that the potential of N1 does not have a step caused by the coupling effect of C1, N2 is not electrically connected to the capacitor, and the potential of N2 also does not have a step caused by the coupling effect of the capacitor. As a result, the potentials of N1 and N2 are more stable compared with those of the related driving circuit, and there is no coupling fluctuation while the power consumption of the driving circuit can be reduced. Meanwhile, at the seventh stage t7, the potential waveforms of N1 and N2 have no step, and the waveform of the driving signal output by the driving circuit also has no step, which is more conducive to data writing.

FIG. 12 illustrates a simulation operation timing diagram of at least one implementation of the driving circuit shown in FIG. 10.

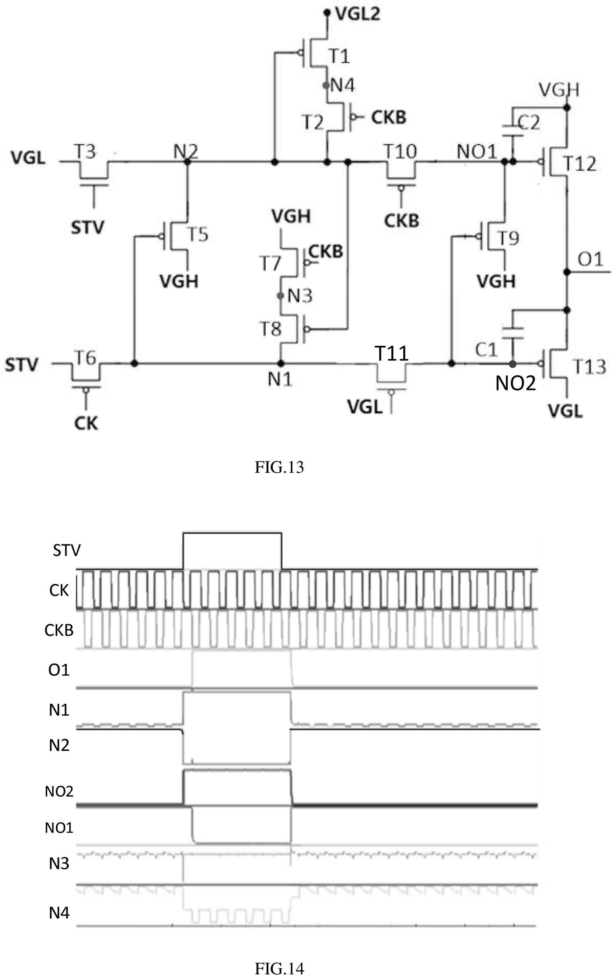

At least one implementation of the driving circuit shown in FIG. 13 is different from at least one implementation of the driving circuit shown in FIG. 10 in that an on-off control circuit is added;
the on-off control circuit includes an eleventh transistor T11;
a gate of the eleventh transistor T11 is electrically connected to the first voltage line VGL, a source of the eleventh transistor T11 is electrically connected to the first node N1, and a drain of the eleventh transistor T11 is electrically connected to a second output node NO2.

T11 is a p-type transistor.

During the operation of at least one implementation of the driving circuit shown in FIG. 10, the charges held by C1 will leak through T6 in one frame time. At least one implementation of the driving circuit shown in FIG. 13 adds a voltage stabilizing transistor (the eleventh transistor T11), which can stabilize the charges held by C2 and effectively reduce the leakage at N1.

FIG. 14 illustrates a simulation operation timing diagram of at least one implementation of the driving circuit shown in FIG. 13.

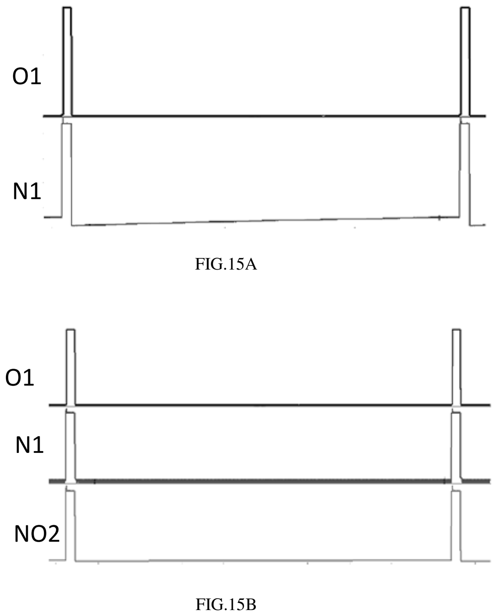

FIG. 15A illustrates a waveform diagram of a potential of a first node N1 and a driving signal in at least one implementation of the driving circuit shown in FIG. 10, and FIG. 15B illustrates a waveform diagram of a potential of a first node N1, a potential of a second output node NO2 and a driving signal in at least one implementation of the driving circuit shown in FIG. 13.

As shown in FIG. 15B, during the operation of at least one implementation of the driving circuit shown in FIG. 13, the potential of N1 will not increase due to leakage.

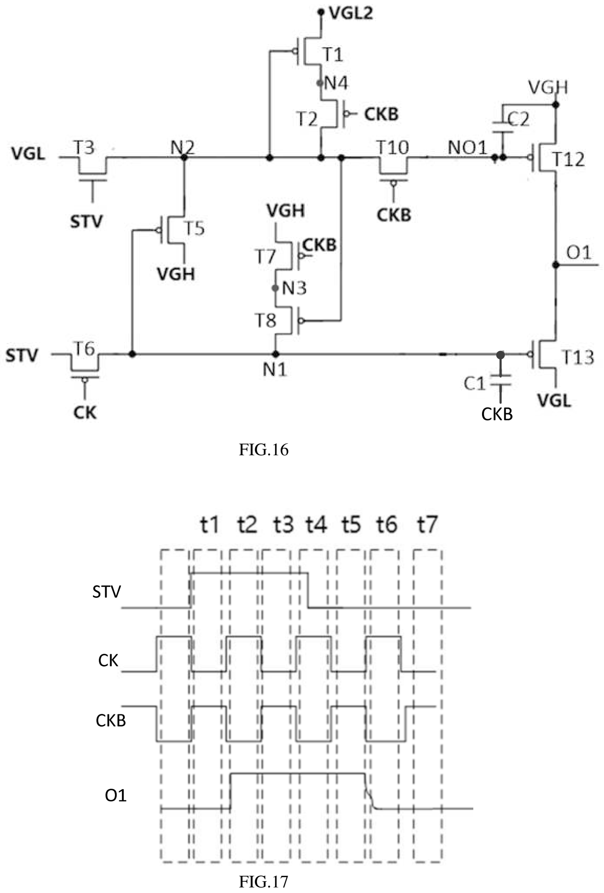

At least one implementation of the driving circuit shown in FIG. 16 is different from at least one implementation of the driving circuit shown in FIG. 10 in that T9 is removed and the second end of C1 is electrically connected to the first clock signal line CKB instead.

FIG. 17 illustrates an operation timing diagram of at least one implementation of the driving circuit shown in FIG. 16.

At least one implementation of the driving circuit shown in FIG. 10, at least one implementation of the driving circuit shown in FIG. 13 and at least one implementation of the driving circuit shown in FIG. 16 should be applied together with Low Temperature Polycrystalline Oxide (LTPO) products.

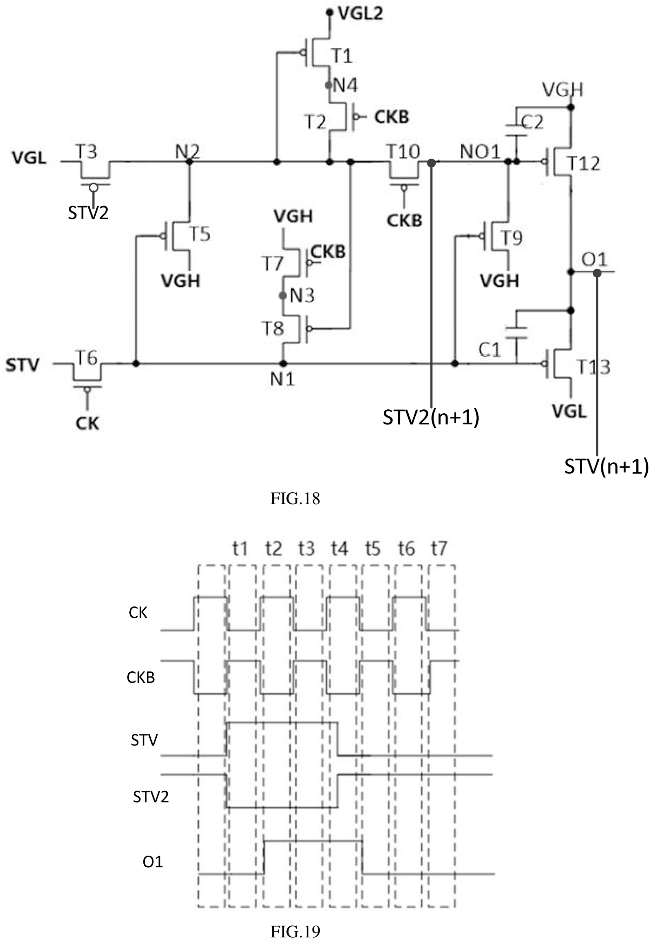

At least one implementation of the driving circuit shown in FIG. 18 is different from at least one implementation of the driving circuit shown in FIG. 10 in that:
T3 is a p-type transistor, and a gate of T3 is electrically connected to an inverting input end STV2;
the first output node NO1 is electrically connected to an adjacent next-stage inverting input end STV2 (n+1), and the driving output O1 is electrically connected to an adjacent next-stage input end STV (n+1);
an inverting input signal provided by the inverting input end STV2 is inverted from an input signal provided by STV.

During the operation of at least one implementation of the driving circuit shown in FIG. 18, the potential of NO1 is set by STV2 (n+1) and the driving signal output by O1 is set by STV (n+1). At least one implementation of the driving circuit shown in FIG. 18 also has no step of an output falling edge, and is suitable for the Low Temperature Polysilicon (LTPS) products and the LTPO products.

FIG. 19 illustrates an operation timing diagram of at least one implementation of the driving circuit shown in FIG. 18.

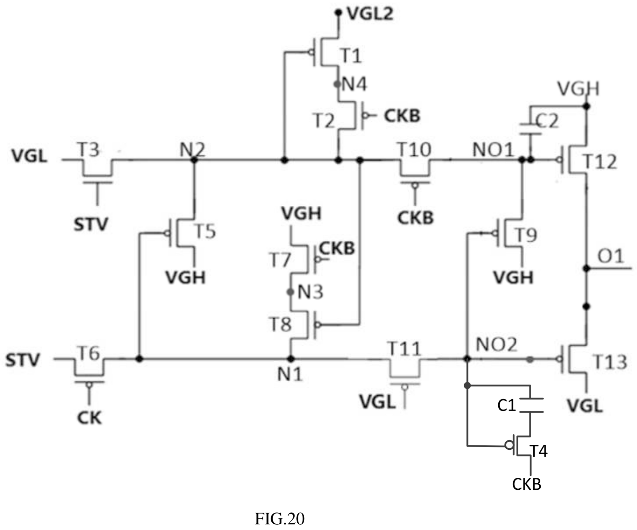

At least one implementation of the driving circuit shown in FIG. 20 is different from at least one implementation of the driving circuit shown in FIG. 13 in that:
at least one implementation of the driving circuit shown in FIG. 20 further includes an energy storage control circuit;
the energy storage control circuit includes a fourth transistor T4;
a first end of the first capacitor C1 is electrically connected to a second output node NO2, and a second end of the first capacitor is electrically connected to an energy storage node NC;
a gate of the fourth transistor T4 is electrically connected to the second output node NO2, a source of the fourth transistor T4 is electrically connected to the energy storage node NC, and a drain of the fourth transistor T4 is electrically connected to the first clock signal line CKB.

In at least one implementation of the driving circuit shown in FIG. 20, T4 is a p-type transistor.

At least one implementation of the driving circuit shown in FIG. 20 adds a secondary pull-down unit. When the potential of NO2 is at a low voltage, the potential of NO2 will be pulled down every time the potential of the first clock signal provided by CKB drops to a low level, so that the pull-down capability of NO2 is stronger and the driving signal output by O1 is more stable.

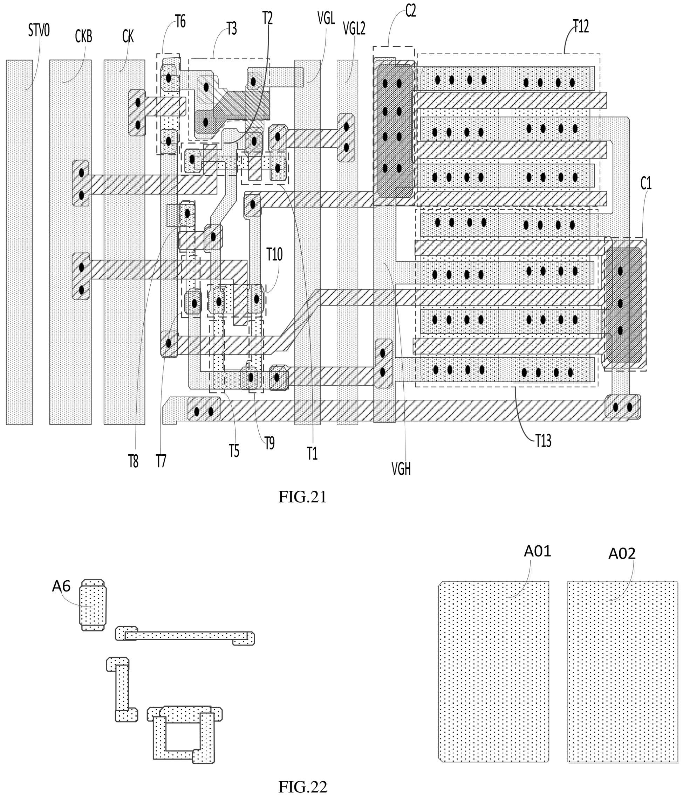

FIG. 21 illustrates a layout diagram of at least one implementation of the driving circuit shown in FIG. 10.

In FIG. 21, STV0 denotes an initial voltage line, CKB denotes a first clock signal line, CK denotes a second clock signal line, VGL denotes a first low-voltage signal, VGL2 denotes a second low voltage line, and VGH denotes a high voltage line.

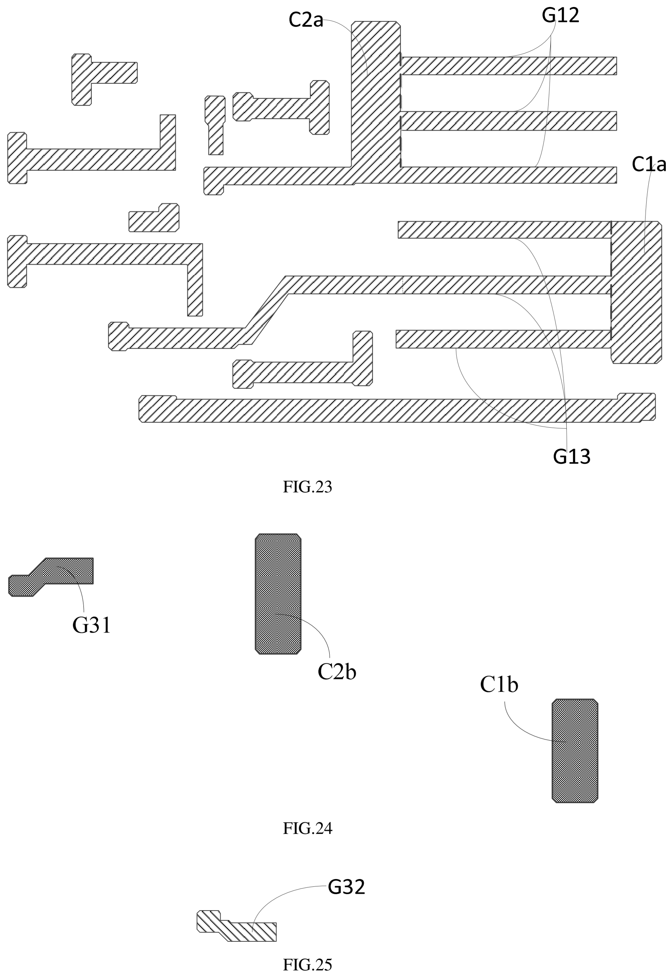

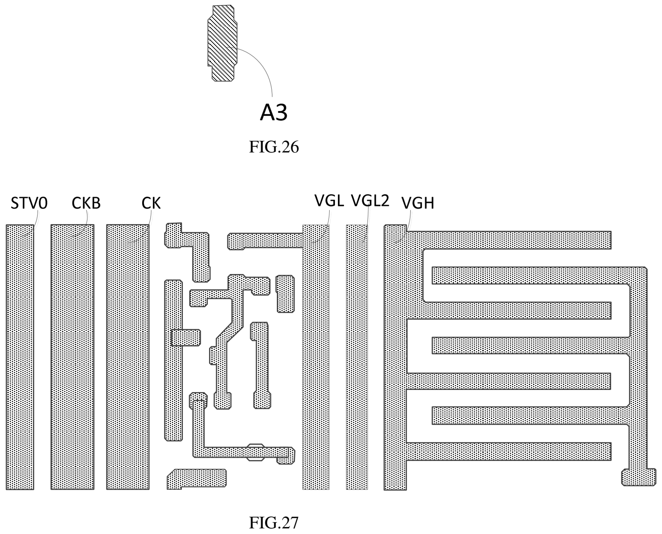

FIG. 22 illustrates a layout diagram of a first semiconductor layer in FIG. 21, FIG. 23 illustrates a layout diagram of a first gate metal layer in FIG. 21, FIG. 24 illustrates a layout diagram of a second gate metal layer in FIG. 21, FIG. 25 illustrates a layout diagram of a third gate metal layer in FIG. 21, FIG. 26 illustrates a layout diagram of a second semiconductor layer in FIG. 21, and FIG. 27 illustrates a layout diagram of a source-drain metal layer in FIG. 21.

During implementation, the first semiconductor layer, the first gate metal layer, the second gate metal layer, the second semiconductor layer, the third gate metal layer and the source-drain metal layer are arranged in sequence along a direction away from a substrate.

In FIG. 22, A01 denotes a first active pattern, A02 denotes a second active pattern, and A6 denotes an active pattern of T6.

An upper half of A01 and an upper half of A02 serve as an active pattern of T12, and a lower half of A01 and a lower half of A02 serve as an active pattern of T13.

Optionally, the first semiconductor layer may be made of polysilicon.

In FIG. 23, G12 denotes a gate of T12, G13 denotes a gate of T13, C1a denotes a first plate of C1, and C2a denotes a second plate of C2.

In FIG. 24, C1b denotes a second plate of C1b, C2b denotes a second plate of C2, and G31 denotes a gate of T3.

In FIG. 25, G32 denotes a second gate of T3.

In FIG. 26, A3 denotes an active pattern of T3. Optionally, the second semiconductor layer may be made of indium gallium zinc oxide (IGZO).

In FIG. 27, STV0 denotes an initial voltage line, CKB denotes a first clock signal line, CK denotes a second clock signal line, VGLdenotes a first low-voltage signal, VGL2 denotes a second low voltage line, and VGH denotes a high voltage line.

In at least one embodiment of the present disclosure, T3 may be a double-gate transistor, which is not limited herein.

Due to the oxide process, double gates can make the characteristics of the oxide transistor more stable, so T3 is set as a double-gate transistor.

In at least one embodiment of the present disclosure, the driving circuit only includes two capacitors, so that the number of capacitors used can be decreased, and the space occupied by the driving circuit can be reduced.

A driving method according to an embodiment of the present disclosure is applied to the above driving circuit, and the driving method includes:
a first node control circuit controls a potential of a first node;
a first control circuit controls the connection or disconnection between a second node and a first voltage line under the control of a setting control signal;
a second control circuit controls the connection or disconnection between the second node and a second voltage line under the control of a first clock signal and a potential of the second node;
an output node control circuit controls the connection or disconnection between the second node and a first output node under the control of the first clock signal; and
an output circuit controls a driving output end to output a driving signal under the control of a potential of the first output node and a potential of a second output node.

A display apparatus according to an embodiment of the present disclosure includes the above driving circuit.

Those described above are the preferred embodiments of the present disclosure. To be pointed out, persons of ordinary skill in the art can make several improvements and modifications without departing from the principle of the present disclosure, and these improvements and modifications should also be regarded as falling within the protection scope of the present disclosure.

## Claims

1. A driving circuit, comprising a first node control circuit, a first control circuit, a second control circuit, an output node control circuit, a first energy storage circuit and an output circuit;
the first node control circuit is electrically connected to a first node and is configured to control a potential of the first node;
the first control circuit is electrically connected to a setting control end, a first voltage line and a second node, respectively, and is configured to control the connection or disconnection between the second node and the first voltage line under the control of a setting control signal provided by the setting control end;
the second control circuit is electrically connected to a first clock signal line, the second node and a second voltage line, respectively, and is configured to control the connection or disconnection between the second node and the second voltage line under the control of a first clock signal provided by the first clock signal line and a potential of the second node;
the output node control circuit is electrically connected to the first clock signal line, the second node and a first output node, respectively, and is configured to control the connection or disconnection between the second node and the first output node under the control of the first clock signal;
the first energy storage circuit is electrically connected to a second output node and is configured to store electric energy;
the output circuit is electrically connected to the first output node, the second output node and a driving output end, respectively, and is configured to control the driving output end to output a driving signal under the control of a potential of the first output node and a potential of the second output node.

2. The driving circuit according to claim 1, wherein a first end of the first energy storage circuit is electrically connected to the second output node, and a second end of the first energy storage circuit is electrically connected to the driving output end.

3. The driving circuit according to claim 1, wherein the first node and the second output node are the same node; or,
the drive circuit further comprises an on-off control circuit; the first node is electrically connected to the second output node through the on-off control circuit; a control end of the on-off control circuit is electrically connected to a third voltage line, and the on-off control circuit is configured to control the connection or disconnection between the first node and the second output node under the control of a third voltage signal provided by the third voltage line.

4. The driving circuit according to claim 1, further comprising an energy storage control circuit;
the energy storage control circuit is electrically connected to the second output node, the first clock signal line and an energy storage node, respectively, and is configured to control the connection or disconnection between the first clock signal line and the energy storage node under the control of the potential of the second output node;
a first end of the first energy storage circuit is electrically connected to the second output node, and a second end of the first energy storage circuit is electrically connected to the energy storage node.

5. The driving circuit according to claim 1, wherein a first end of the first energy storage circuit is electrically connected to the second output node, and a second end of the first energy storage circuit is electrically connected to the first clock signal line.

6. The driving circuit according to any one of claims 1 to 5, further comprising a third control circuit;
the third control circuit is electrically connected to the second output node, the first output node and a fourth voltage line, respectively, and is configured to control the connection or disconnection between the first output node and the fourth voltage line under the control of the potential of the second output node; or,
the third control circuit is electrically connected to the first node, the first output node and a fourth voltage line respectively, and is configured to control the connection or disconnection between the first output node and the fourth voltage line under the control of the potential of the first node.

7. The driving circuit according to any one of claims 1 to 5, further comprising a fourth control circuit;
the fourth control circuit is electrically connected to the first node, a fourth voltage line and the second node, respectively, and is configured to control the connection or disconnection between the second node and the fourth voltage line under the control of the potential of the first node.

8. The driving circuit according to any one of claims 1 to 5, further comprising a second energy storage circuit which is electrically connected to the first output node to store electric energy.

9. The driving circuit according to any one of claims 1 to 5, wherein the second control circuit comprises a first transistor and a second transistor;
a gate of the first transistor is electrically connected to the second node, a first pole of the first transistor is electrically connected to the second voltage line, and a second pole of the first transistor is electrically connected to a first pole of the second transistor;
a gate of the second transistor is electrically connected to the first clock signal line, and a second pole of the second transistor is electrically connected to the second node.

10. The driving circuit according to any one of claims 1 to 5, wherein the first control circuit comprises a third transistor; and the setting control end is an input end;
a gate of the third transistor is electrically connected to the input end, a first pole of the third transistor is electrically connected to the first voltage line, and a second pole of the third transistor is electrically connected to the second node;
the third transistor is an oxide transistor.

11. The driving circuit according to any one of claims 1 to 5, wherein the setting control end is an inverting input end; and the first control circuit comprises a third transistor;
a gate of the third transistor is electrically connected to the inverting input end, a first pole of the third transistor is electrically connected to the first voltage line, and a second pole of the third transistor is electrically connected to the second node;
the third transistor is a p-type transistor;
the inverting input end is configured to provide an inverting input signal, which is inverted from an input signal provided by the input end.

12. The driving circuit according to claim 11, wherein the first output node is electrically connected to an adjacent next-stage inverting input end, and the driving output end is electrically connected to an adjacent next-stage input end.

13. The driving circuit according to claim 2, wherein the first energy storage circuit comprises a first capacitor;
a first end of the first capacitor is electrically connected to the second output node, and a second end of the first capacitor is electrically connected to the driving output end.

14. The driving circuit according to claim 5, wherein the first energy storage circuit comprises a first capacitor;
a first end of the first capacitor is electrically connected to the second output node, and a second end of the first capacitor is electrically connected to the first clock signal line.

15. The driving circuit according to claim 4, wherein the first energy storage circuit comprises a first capacitor, and the energy storage control circuit comprises a fourth transistor;
a first end of the first capacitor is electrically connected to the second output node; and a second end of the first capacitor is electrically connected to the energy storage node;
a gate of the fourth transistor is electrically connected to the second output node, a first pole of the fourth transistor is electrically connected to the energy storage node, and a second pole of the fourth transistor is electrically connected to the first clock signal line.

16. The driving circuit according to claim 7, wherein the fourth control circuit comprises a fifth transistor;
a gate of the fifth transistor is electrically connected to the first node, a first pole of the fifth transistor is electrically connected to the fourth voltage line, and a second pole of the fifth transistor is electrically connected to the second node.

17. The driving circuit according to any one of claims 1 to 5, wherein the first node control circuit is further electrically connected to an input end, a second node, a second clock signal line, a first clock signal line and a fourth voltage line, respectively, and is configured to control the connection or disconnection between the first node and the input end under the control of a second clock signal provided by the second clock signal line, and control the connection or disconnection between the first node and the fourth voltage line under the control of the first clock signal and the potential of the second node.

18. The driving circuit according to claim 17, wherein the first node control circuit comprises a sixth transistor, a seventh transistor and an eighth transistor;
a gate of the sixth transistor is electrically connected to the second clock signal line, a first pole of the sixth transistor is electrically connected to the input end, and a second pole of the sixth transistor is electrically connected to the first node;
a gate of the seventh transistor is electrically connected to the first clock signal line, a first pole of the seventh transistor is electrically connected to the fourth voltage line, and a second pole of the seventh transistor is electrically connected to a first pole of the eighth transistor;
a gate of the eighth transistor is electrically connected to the second node, and a second pole of the eighth transistor is electrically connected to the first node.

19. The driving circuit according to claim 6, wherein the third control circuit comprises a ninth transistor;
a gate of the ninth transistor is electrically connected to the second output node, a first pole of the ninth transistor is electrically connected to the fourth voltage line, and a second pole of the ninth transistor is electrically connected to the first output node.

20. The driving circuit according to any one of claims 1 to 5, wherein the output node control circuit comprises a tenth transistor;
a gate of the tenth transistor is electrically connected to the first clock signal line, a first pole of the tenth transistor is electrically connected to the second node, and a second pole of the tenth transistor is electrically connected to the first output node.

21. The driving circuit according to claim 3, wherein the driving circuit further comprises an on-off control circuit;
the on-off control circuit comprises an eleventh transistor;
a gate of the eleventh transistor is electrically connected to the third voltage line, a first pole of the eleventh transistor is electrically connected to the first node, and a second pole of the eleventh transistor is electrically connected to the second output node.

22. The driving circuit according to any one of claims 1 to 5, wherein the output circuit comprises a twelfth transistor and a thirteenth transistor;
a gate of the twelfth transistor is electrically connected to the first output node, a first pole of the twelfth transistor is electrically connected to a fifth voltage line, and a second pole of the twelfth transistor is electrically connected to the driving output end;
a gate of the thirteenth transistor is electrically connected to the second output node, a first pole of the thirteenth transistor is electrically connected to the driving output end, and a second pole of the thirteenth transistor is electrically connected to a sixth voltage line.

23. A driving method applied to the driving circuit according to any one of claims 1 to 22, the driving method comprising:
controlling, by a first node control circuit, a potential of a first node;
controlling, by a first control circuit, the connection or disconnection between a second node and a first voltage line under the control of a setting control signal;
controlling, by a second control circuit, the connection or disconnection between the second node and a second voltage line under the control of a first clock signal and a potential of the second node;
controlling, by an output node control circuit, the connection or disconnection between the second node and a first output node under the control of the first clock signal; and
controlling, by an output circuit, a driving output end to output a driving signal under the control of a potential of the first output node and a potential of a second output node.

24. A display apparatus, comprising the driving circuit according to any one of claims 1 to 22.
